Europäisches Patentamt

(19) European Patent Office

Office européen des brevets

(11) **EP 0 588 240 B1**

(12) **EUROPEAN PATENT SPECIFICATION**

(45) Date of publication and mention
of the grant of the patent:
**27.03.1996 Bulletin 1996/13**

(51) Int. Cl.$^6$: **C04B 35/00**

(21) Application number: **93114504.9**

(22) Date of filing: **09.09.1993**

(54) **Bi-type high-temperature superconducting oxide material and method of producing the same**

Wismut-enthaltender hochtemperatursupraleitender Oxydwerkstoff und Verfahren zur Herstellung desselben

Matériau oxyde supraconductrice à température élevée contenant Bismuth, et procédé pour sa préparation

(84) Designated Contracting States:
**DE FR GB**

(30) Priority: **11.09.1992 JP 243352/92**

(43) Date of publication of application:
**23.03.1994 Bulletin 1994/12**

(73) Proprietors:
• **MITSUBISHI DENKI KABUSHIKI KAISHA**
**Tokyo 100 (JP)**
• **INTERNATIONAL SUPERCONDUCTIVITY**
**TECHNOLOGY CENTER**
**Tokyo 105 (JP)**
• **THE TOKYO ELECTRIC POWER COMPANY,**
**INCORPORATED**
**Chiyoda-ku Tokyo-to 100 (JP)**

(72) Inventors:
• **Wang, Jie,**
**c/o Int. Superconductivity Tech. Ctr**
**Tokyo 135 (JP)**
• **Wakata, Mitsunobu,**
**c/o Int. Superconduct. Tech.Ctr**
**Tokyo 135 (JP)**

• **Takano, Satoshi,**
**c/o Int. Superconduct. Tech. Ctr**
**Tokyo 135 (JP)**
• **Yamauchi, Hisao,**
**c/o Int. Superconduct. Tech. Ctr**
**Tokyo 135 (JP)**

(74) Representative: **Pfenning, Meinig & Partner**
**Mozartstrasse 17**
**D-80336 München (DE)**

(56) References cited:
EP-A- 0 336 450          EP-A- 0 348 650
EP-A- 0 371 453          WO-A-91/00622

• JAPANESE JOURNAL OF APPLIED PHYSICS vol. 27, no. 8 , August 1988 pages L1429 - L1431 Y.OKA ET AL. 'CRYSTAL PHASES OF BISRCACU2OX HEAT TREATED IN A VACUUM-SEALED SYSTEM'
• PATENT ABSTRACTS OF JAPAN vol. 016, no. 431 (C-0983)9 September 1992 & JP-A-04 149 060 (SUMITOMO) 22 May 1992
• PATENT ABSTRACTS OF JAPAN vol. 016, no. 431 (C-0983)9 September 1992 & JP-A-04 149 060

## Description

BACKGROUND OF THE INVENTION

Field of the Invention:

The present invention relates to a Bi-type high-temperature superconducting material for use under high magnetic field, such as a material of a superconducting magnet, and also to a method of producing such a material.

Description of the Related Arts:

High-temperature superconducting oxide materials inherently exhibit not only high levels of critical temperature (Tc) but also high levels of upper critical magnetic field ($Bc_2$) and critical current density (Jc) and, therefore, are expected to find spreading use as materials of conductor wires of superconducting magnets, magnetic shields and power leads. In particular, this type of superconducting oxide materials can theoretically be realized with cooling at comparatively high temperature of 77 K which is obtainable with liquefied nitrogen, in contrast to known metallic superconducting material which requires cooling down to low temperature of 4.2 K or so using liquefied helium. Realizing superconducting materials operable at such high temperature will not only contribute to miniaturization, simplification and cost reduction of systems using superconducting technologies but also will significantly expand the application of such technologies.

One of such promising materials is a Bi-2223 phase material which has a critical temperature Tc exceeding 100 K, and development and attempt have been vigorously done to apply this material to superconducting wires, power leads and so forth. Factors or characteristics important in the development of superconducting materials are upper critical magnetic field $Bc_2$ and critical current density Jc at the temperature T of use. How to elevate the levels these factors is therefore a matter of great significance. In order to improve such characteristics, hitherto, various attempts have been made such as improvement in the superconducting weak bonds between the crystal grains through orientation control, introduction of pinning point, and so on.

It is known that these physical amount is a monotonous decreasing function of $t = T/Tc$. Increasing the value of Tc, therefore, is quite effective in improving the critical current density, Jc. The critical temperature Tc of high-temperature superconducting oxide material is a function of the density of carriers, mostly holes, which contribute to electrical conduction. It has been experimentally known that the critical temperature Tc is maximized when the carrier density takes a certain optimum value. At the present stage, the mechanism which develops the superconducting phenomenon at high temperature has not been theoretically clarified yet and, hence, parameters upon which the critical temperature Tc depend are still unknown, although test and examination are being done on each of materials.

B-2212 phase is a system which allows many element substitutions and control of oxygen content. Control of carrier density is comparatively easy in such a system. In other words, it is possible to widely vary the value of the critical temperature Tc. In case of the Bi-2223 phase mentioned above, however, it is difficult to effect such a control of the carrier density. Thus, the maximum reproducible critical temperature Tc with this type of material has been 110 K or so.

SUMMARY OF THE INVENTION

Accordingly, an object of the present invention is to provide a Bi-2223 phase high-temperature superconducting oxide material having an elevated critical temperature Tc, as well as a method which can realize such a material with a high degree of reproducibility.

To these ends, according to the present invention, there is provided a Bi-type high-temperature superconducting oxide material which has a composition expressed by the following general formula (1) and a crystalline structure which is the same as that of Bi-2223 structure, with the lattice constants falling within the ranges of $5.402\text{Å} \leq a \leq 5.412\text{Å}$ and $c \geq 37.06\text{Å}$ :

$$Bi_{2.2-\delta}Pb_\delta Sr_{2-x}Ca_{2+x}Cu_{3+\varepsilon}O_y \qquad (1)$$

wherein $0.2 \leq \delta \leq 0.4$, $0 \leq x \leq 0.3$, $0.05 \leq \varepsilon \leq 0.4$

When the value of the parameter $\delta$ is smaller than 0.2 ($\delta < 0.2$), it is not easy to form the Bi-2223 phase, whereas, when this parameter exceeds 0.4 ($\delta > 0.4$), impurities are precipitated to make it impossible to obtain a single phase. When the value of the parameter x is below 0 (x < 0), Bi-2212 phase also is generated, whereas a value of x exceeding 0.3 (x > 0.3) inconveniently permits generation of Bi-2201 phase. Single phase cannot be obtained under the condition of $\varepsilon < 0.05$ or $\varepsilon > 0.4$. At the present standard of technology, there is no means for analyzing the oxygen content y. It is also necessary that the above-mentioned requirements for the lattice constants a and c are met, otherwise the critical temperature cannot be elevated beyond 110 K.

In another aspect of the present invention, there is provided a method of producing a Bi-type high-temperature superconducting oxide material comprising the steps of: preparing a mixture powder from powders of raw materials, baking the mixture powder in an atmosphere having oxygen partial pressure not higher than 20 kPa (0.2 atm) at a temperature ranging from 840 to 870 °C, and heat-treating the baked mixture powder in a hermetic vessel maintaining a pressure not higher than 1 kPa (0.01 atm) at a temperature lower than 800 °C.

Preferably, the baking is conducted for a period not shorter than 50 hours.

Preferably, the mixture powder is prepared by mixing the powders of raw materials at a predetermined mixing ratio, dissolving the mixture in an acidic solution, drying the solution to obtain an acid salt powder, rapidly heating the acid salt powder in air up to 800 °C or higher, holding the powder at this temperature, and cooling the powder.

When the oxygen partial pressure of the baking atmosphere exceeds 20 kPa (0.2 atm), the temperature range for obtaining the single phase is inconveniently narrowed to make the control difficult. The baking temperature range of 840 to 870 °C is essential for synthesizing the Bi-2223 single phase. The oxygen partial pressure of the post heat-treating atmosphere should not exceed 1 kPa (0.01 atm), otherwise critical temperature Tc not lower than 110 K cannot be obtained. Post heat-treatment at temperatures exceeding 800 °C undesirably causes decomposition of the Bi-2223 phase. Critical temperature Tc of 110 K or higher cannot be obtained when the period of the post heat-treatment is shorter than 50 hours.

The spray drying technique employed in the method of the invention is preferred in order to obtain good single-phase samples with high degree of composition uniformity, as compared with ordinary solid-phase technique which employs, as the starting materials, powders of oxides and carbonates of different materials. It is also understood that other methods such as freeze-dry method, co-precipitation method and sol-gel method will be used equally well.

The above and other objects, features and advantages of the present invention will become clear from the following detailed description of the invention.

BRIEF DESCRIPTION OF THE DRAWINGS

Fig. 1 is a diagram showing X-ray diffraction patterns of samples used in Example 1;

Fig. 2 is a chart illustrative of the temperature-dependency of DC magnetization of samples employed in Example 1;

Fig. 3 shows the temperature dependence of the resistivity for some samples employed in Example 1, wherein Sample A was as sintered, Sample E was post-annealed at 790 °C for 240 hours in a vacuum after sintering and Sample F was obtained by heat-treating Sample E at 750 °C for 6 hours in the atmosphere of 0.1 % $O_2$-$N_2$ mixture gas;

Fig. 4 is a diagram showing the X-ray diffraction pattern of a sample C which has undergone a 200-hour post-heat treatment in Example 2 of the invention;

Fig. 5 is a chart showing the temperature dependencies of the resistivity of samples after sintering in Example 2;

Fig. 6 is a chart showing the temperature dependency of DC magnetization of a sample C employed in Example 2; and

Fig. 7 is an illustration of the relationship between critical temperature Tc and lattice constants as determined from the magnetization of the samples employed in Examples 1 and 2.

DETAILED DESCRIPTION OF THE INVENTION

Example 1

Powders of $Bi_2O_3$, PbO, $CaCO_3$, $SrCO_3$ and CuO are prepared at purity of 99.9 % or higher, and were mixed to form 20 g of a mixture having a composition expressed by $Bi_{1.85}Pb_{0.35}Sr_{1.9}Ca_{2.1}Cu_{3.1}O_y$. An aqueous solution of nitrate was obtained by dissolving the above-mentioned mixture in nitric acid which was prepared by adding 50 cc of concentrated nitric acid to 350 cc of water. The solution was then sprayed and dried by means of a commercially available small-sized spray drier (Pulvis Mini-Spray Model GA-32), whereby a nitrate mixture powder was obtained. The thus obtained powder was subjected to 15-minute heat treatment conducted at 850 °C for decomposition and calcination. In this heat-treatment, the temperature was risen at a rate of 30 °C or greater. The calcined powder was then press-formed into a rod-shaped compact body of 3 mm x 2 mm x 20 mm. The rod-shaped compacted body was then subjected to a sintering heat treatment which was conducted in an atmosphere having an oxygen partial pressure of 0.076 atm for 100 hours or longer at 840 °C. In order to enhance the reactivity, at least one crushing/press-forming process was required during the sintering heat treatment. The rate of temperature rise in the sintering heat treatment was 5 °C /min. A sample of Bi-2223 single phase was obtained through the above-described process. Each of a plurality of sintered rod, each being about 0.1 g in weight, was wrapped with a gold foil and was placed in a quartz glass tube of 10 mm diameter closed at one end. The interior of the quartz glass tube was evacuated to 0.013 Pa ($10^{-4}$ Torr) and the other end of this tube was sealed and cut so as to provide a tube length of 8 cm. The sample thus prepared was subjected to a post heat-treatment conducted at 790 °C . The period of the post heat treatment was varied within the range between 1 day and 10 days.

Identification of phases of the sample after the sintering and after the post heat-treatment was conducted by using powder X-ray diffraction technique.

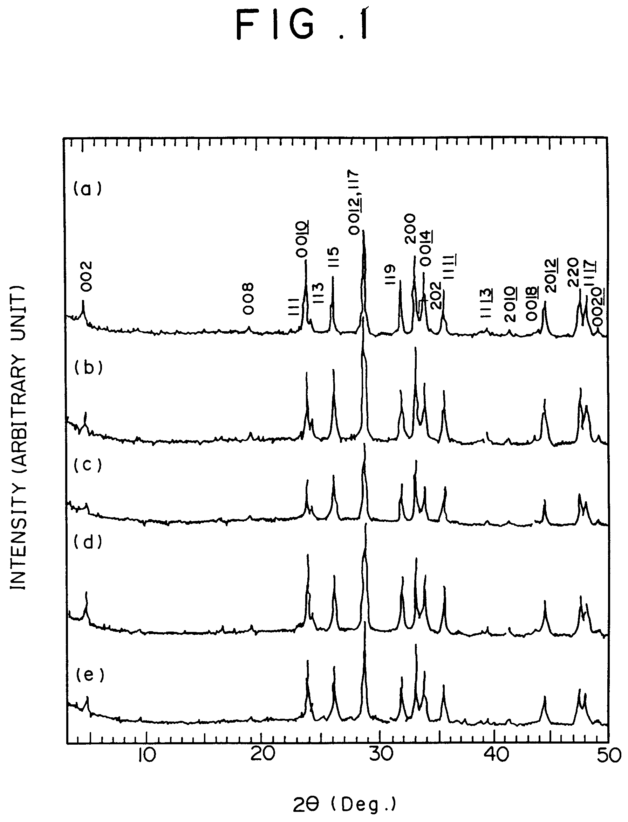

Fig. 1(a) shows the X-ray diffraction patterns of the sample after the sintering. All the diffraction peaks correspond to those of Bi-2223 single phase. Diffraction patterns were not substantially changed even after the post heat-treatment conducted at 790 °C for the periods of 30 hours (Fig. 1(b)), 60 hours (Fig. 1(c)), 120 hours (Fig. 1(d)) and 240 hours (Fig. 1(e)), proving that the Bi-2223 single phase was maintained even after the post heat-treatment. The result of the test described above indicates that the Bi-2223 phase synthesized under the described conditions is thermally stable. It is also understood that the Bi-2223 phase is never decomposed by the post heat-treatment.

The superconducting critical temperature Tc of the sample was determined by measuring the temperature dependency of the magnetization of the sample in the course of cooling down of the sample under the influence of a magnetic field of 796 Ampm (10 Oe), using a DC magnetization measuring instrument (produced by Quantum Design Co., Ltd, Model MPMS).

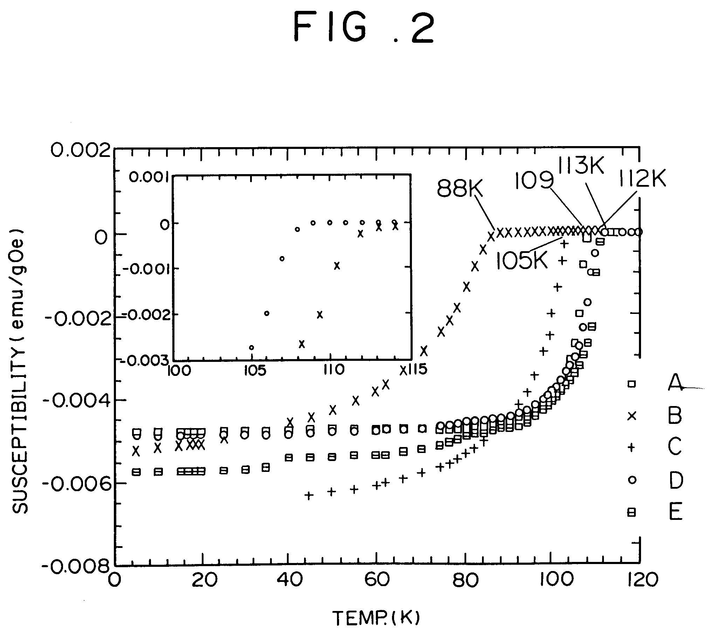

As will be seen from Fig. 2, the sample A after the sintering exhibited a superconducting critical temperature Tc of 109 K, thus showing a sharp transition. The critical temperature Tc was reduced to 88 K and 105 K, respectively, in the samples B and C which have undergone 30-hour post heat-treatment and 60-hour post heat-treatment at 790 °C. In contrast, Sample D which has undergone 120-hour post heat-treatment showed a rise of the critical temperature Tc to 113 K which is 4 K higher than that of the as-sintered sample. Sample E which has undergone a longer (240 hours) post heat-treatment showed almost the same level of the critical temperature Tc. These samples showed superconducting volume fraction of 40 % or greater at 5 K, thus proving that superconductivity in bulk state existed.

The temperature-dependency of electrical resistivity of these samples were measured by a standard four probes method.

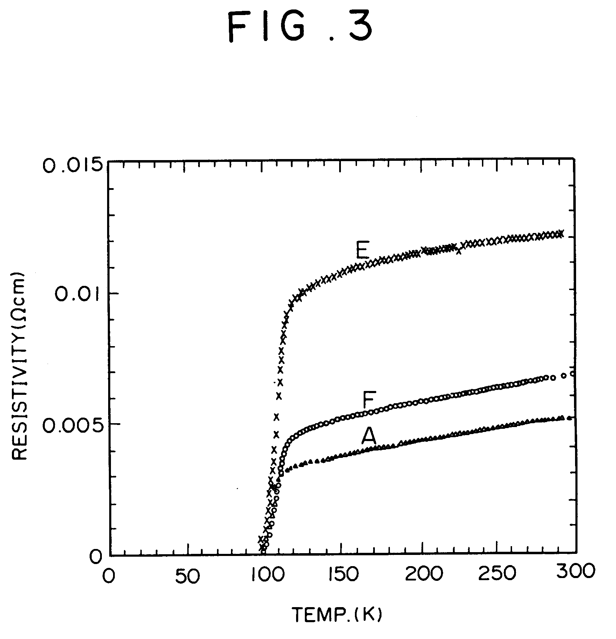

Fig. 3 shows the relationship between the results measured on Sample A and Sample E. The temperature Tc (R= 0) at which the resistivity is reduced to zero was 100 K in case of Sample A. Sample E which has undergone the 240-hour post heat-treatment showed almost the same result. However, the temperature Tc (onset) at which the resistance starts to decrease drastically was elevated from 108 K to 116 K as a result of the 240-hour post heat-treatment. Sample F was obtained by heat-treating Sample E for 6 hours at 750 °C in the atmosphere of 0.1% $O_2$-$N_2$ mixture gas. Sample F does not show any change in the temperature Tc (R= 0) and Tc (onset), although the resistivity in normal conduction state was reduced.

The weight loss $\Delta$ m was determined by measuring the weights of the sample before and after the post heat-treatment. Samples after 30-hour post heat-treatment and after 240-hour post heat-treatment showed the weight loss $\Delta$ m of 1 % and 4 %, respectively. It is thus understood that the weight loss increases as the time of the post heat-treatment becomes longer. A composition analysis by ICP showed that the Pb content was reduced by 30 % as a result of the 240-hour post heat-treatment. The rise in the temperature Tc is considered to be attributable to optimization of the hole density caused by a competition between the reduction in the oxygen content and the reduction in the Pb content.

Example 2

A mixture having a composition expressed by $Bi_{1.85}Pb_{0.35}Sr_2Ca_2Cu_{3.1}O_y$ was prepared by a process similar to that in Example 1, and samples of Bi-2223 single phase were obtained. The samples were subjected to vacuum sealing and post heat-treatment conducted under the same conditions as those of Example 1.

The process for synthesizing Bi-2223 single-phase samples was the same as that in Example 1 except for the conditions of the sintering. More specifically, in Example 2, powder was obtained through decomposition reaction conducted at 850 °C for 15 minutes, and was press-formed into rod-shaped samples of 3 mm x 2 mm x 20 mm. The rod-shaped samples were then subjected to sintering heat treatment conducted for 100 hours at 865 °C in a stream of atmospheric air. At least one crushing/press-forming cycle was required also in this Example, in order to enhance reactivity. The rate of temperature rise was 5 °C /min. Samples of Bi-2223 single phase were also obtained through the above-described process.

Samples of about 0.5 g in weight, obtained through the sintering, were sealed in vacuum inside the quartz glass tubes in the same way as Example 1 and were subjected to post heat-treatment conducted at 790 °C for 5 to 10 days.

In Example 2, both the sample as-sintered and the sample after post heat-treatment showed single phase, as in the case of Example 1. This means that formation of the single phase is not affected by slight change in the contents of Sr and Ca.

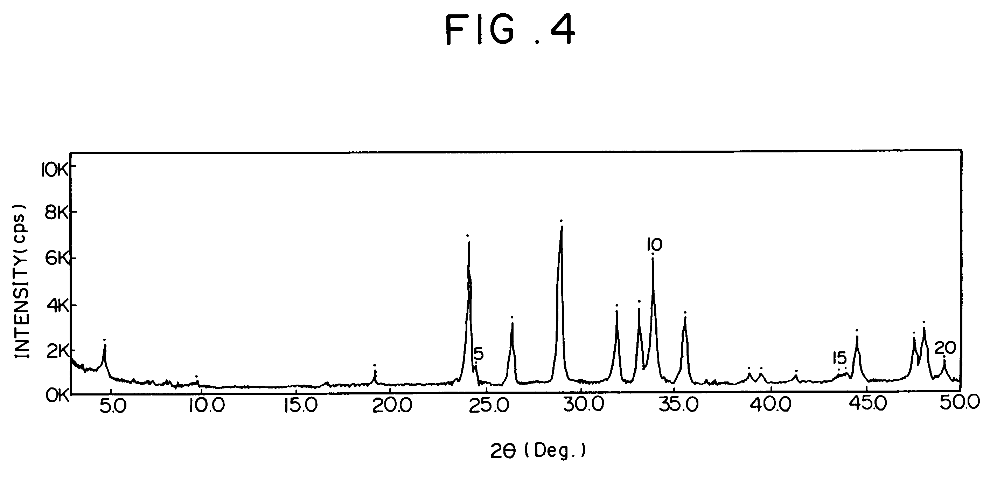

Fig. 4 shows X-ray diffraction pattern of a sample which has undergone 200-hour post heat-treatment. As will be seen from this Figure, no decomposition takes place even when post heat-treatment is conducted for a long period of 10 days or so.

The superconducting characteristics of this sample were evaluated based on the temperature dependency of resistivity and DC magnetization.

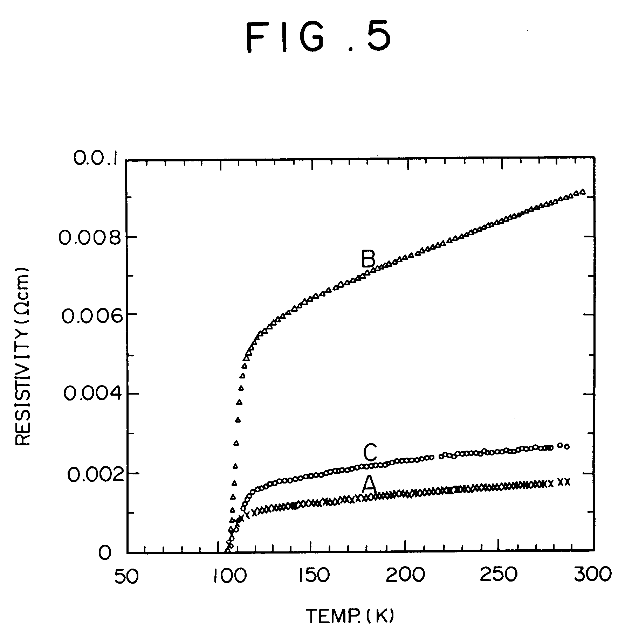

Fig. 5 shows the values of resistivity of Sample A which is the as-sintered sample, Sample B which has undergone 120-hour post heat-treatment and Sample C which has undergone 200-hour heat-treatment. Sample A showed the temperature Tc (R= 0) of 102 K and the temperature Tc (onset) of 111 K. These values are higher than those obtained in Example 1. Sample B, which has undergone 120-hour post heat-treatment, showed a rise of the temperature Tc (onset) to 116 K, although the temperature Tc (R= 0) was not changed. Sample C, which has undergone 200-hour post heat-treatment, showed rise in both the temperature Tc (R= 0) and the temperature Tc (onset) to 111 K and 117 K, respectively.

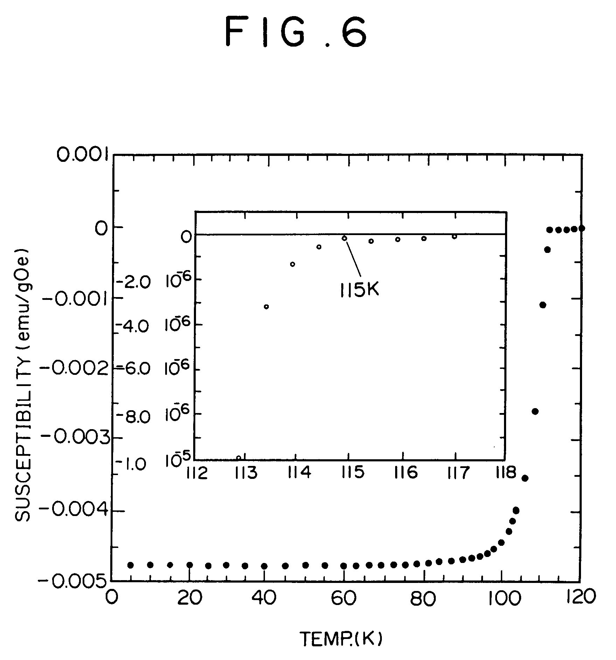

Fig. 6 shows data concerning DC magnetization as measured in the course of cooling of the samples under influence of a magnetic field of 796 Ampm (10 Oe). As will be seen from this Figure, superconducting transition started at 115 K and the superconducting volume fraction at 5 K caused by sharp transition was 40 %.

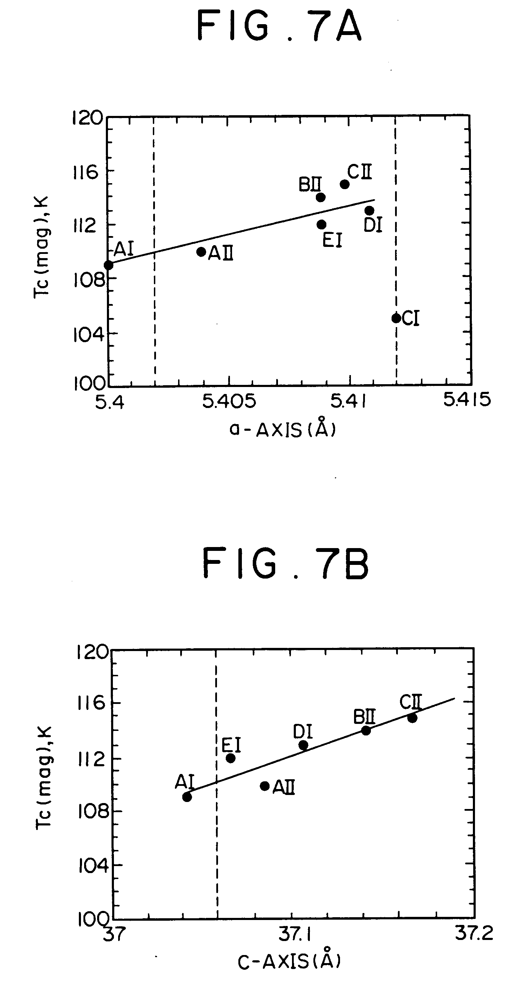

Figs. 7A and 7B respectively show the relationship between the critical temperature Tc (mag.) and the lattice constant $\underline{a}$ and the relationship between the critical temperature Tc (mag.) and the lattice constant $\underline{c}$, as obtained on samples which showed critical temperature Tc (mag.) not lower than 110 K as estimated from the level of magnetization. From Fig. 7A, it will be understood that the materials having the temperature Tc not lower than 110 K possesses a-axial length which falls within a narrow range of 5.402Å $\leq$ a$\leq$ 5.412Å . From Fig. 7B, it will be seen that the greater the c-axis length, the higher the temperature Tc. For instance, the minimal value of Tc, i.e., 110 K, is obtained when the c-axis length is 37.06Å , and a large c-axis length of 37.16Å or so is required for achieving higher Tc of 115 K.

As will be understood from the foregoing description, the present invention provides a Bi-type high-temperature superconducting oxide material which has a composition expressed by general formula (1) and a crystalline structure which is the same as that of Bi-2223 structure, with the lattice constants falling within the ranges of 5.402Å $\leq$ a$\leq$ 5.412Å and c$\geq$ 37.06Å , and which exhibits a critical temperature of 110 K or higher which is higher than those of known materials.

The invention also provides a method of producing a Bi-type high-temperature superconducting oxide material, having the steps of preparing a mixture powder from powders of different materials, baking the mixture powder in an atmosphere having oxygen partial pressure not higher than 20 kPa (0.2 atm.) at a temperature ranging from 840 to 870 °C , and heat-treating the baked mixture powder in a hermetic vessel maintaining a pressure not higher than 1 kPa (0.01 atm) at a temperature lower than 800 °C. With this method, it is possible to obtain, with a high degree of reproducibility, a superconducting material having a critical temperature not lower than 110 K which is higher than those of known materials.

## Claims

1. A Bi-type high-temperature superconducting oxide material which has a composition expressed by the following general formula (1) and a crystalline structure which is the same as that of Bi-2223 structure, with the lattice constants falling within the ranges of 5.402Å $\leq$ a$\leq$ 5.412Å and c$\geq$ 37.06Å :

$$Bi_{2.2-\delta}Pb_\delta Sr_{2-x}Ca_{2+x}Cu_{3+\varepsilon}O_y \qquad (1)$$

wherein 0.2$\leq \delta \leq$ 0.4, 0$\leq$ x $\leq$ 0.3, 0.05$\leq \varepsilon \leq$ 0.4

2. A method of producing a Bi-type high-temperature superconducting oxide material comprising the steps of:

preparing a mixture powder from powders of raw materials,

baking the mixture powder in an atmosphere having oxygen partial pressure not higher than 20 kPa (0.2 atm) at a temperature ranging from 840 to 870 °C , and

heat-treating the baked mixture powder in a hermetic vessel maintaining a pressure not higher than 1 kPa (0.01 atm) at a temperature lower than 800 °C.

3. A method according to Claim 2 wherein the baking is conducted for a period not shorter than 50 hours.

4. A method according to Claim 2 wherein the mixture powder is prepared by mixing the powders of raw materials at a predetermined mixing ratio, dissolving the mixture in an acidic solution, drying the solution to obtain an acid salt powder, rapidly heating the acid salt powder in air up to 800 °C or higher, holding the powder at this temperature, and cooling the powder.

## Patentansprüche

1. Wismut-enthaltendes hochtemperatur-supraleitendes Oxidmaterial, welches eine durch die folgende allgemeine Formel (1) ausgedrückte Zusammensetzung und eine kristalline Struktur hat, die dieselbe ist wie die der Bi-2223-Struktur, wobei die Gitterkonstanten in die Bereiche von 5,402 Å $\leq$ a $\leq$ 5,412 Å und c $\geq$ 37,06 Å fallen:

$$Bi_{2,2-\delta} Pb_\delta Sr_{2-x} Ca_{2+x} Cu_{3+\varepsilon} O_y \qquad (1)$$

worin
0,2 $\leq \delta \leq$ 0,4, 0 $\leq$ x $\leq$ 0,3, 0,05 $\leq \varepsilon \leq$ 0,4.

2. Verfahren zum Herstellen eines Wismut-enthaltenden hochtemperatur-supraleitenden Oxidmaterials, welches die Schritte aufweist:
Vorbereiten eines Mischpulvers aus Pulvern von Ausgangsmaterialien,
Brennen des Mischpulvers in einer Atmosphäre mit einem Sauerstoffteildruck, der nicht höher als 20 kPa (0,2 atm) ist, bei einer Temperatur im Bereich von 840 bis 870 °C, und
Wärmebehandeln des gebrannten Mischpulvers in einem hermetischen Gefäß unter Aufrechterhaltung eines Druckes von nicht mehr als 1 kPa (0,01atm) bei einer Temperatur unterhalb 800 °C.

3. Verfahren nach Anspruch 2, worin das Brennen während einer Zeitspanne durchgeführt wird, die nicht kürzer als 50 Stunden ist.

4. Verfahren nach Anspruch 2, worin das Mischpulver vorbereitet wird durch Mischen der Pulver von Ausgangsmaterialien mit einem vorbestimmten Mischungsverhältnis, Lösen der Mischung in einer sauren Lösung, Trocknen der Lösung, um ein saures Salzpulver zu erhalten, rasches Erwärmen des sauren Salzpulvers in Luft bis zu 800 °C oder höher, Halten des Pulvers bei dieser Temperatur, und Abkühlen des Pulvers.

## Revendications

1. Matériau d'oxyde supraconducteur à haute température du type Bi qui a une composition exprimée par la formule générale (1) suivante et une structure cristalline qui est identique à celle de la structure Bi-2223, avec les constantes du réseau tombant dans les intervalles de 5,402Å $\leq$ a $\leq$ 5,412Å et c $\geq$ 37,06Å :

$$Bi_{2,2-\delta}Pb_\delta Sr_{2-x}Ca_{2+x}Cu_{3+\epsilon}Oy \qquad (1)$$

où $0,2 \leq \delta \leq 0,4$, $0 \leq x \leq 0,3$, $0,05 \leq \epsilon \leq 0,4$

2. Méthode de production d'un matériau d'oxyde supraconducteur à température élevée du type Bi comprenant les étapes de :

préparation d'une poudre de mélange à partir des poudres des matériaux de départ,

cuisson de la poudre de mélange dans une atmosphère ayant une pression partielle d'oxygène non supérieure à 20 KPa (0,2 at) à une température dans l'intervalle de 840 à 870°C, et

traitement thermique de la poudre de mélange cuite dans un récipient hermétique maintenant une pression non supérieure à 1 KPa (0,01 at) à une température inférieure à 800°C.

3. Méthode selon la revendication 2 dans laquelle la cuisson est menée pendant une période non inférieure à 50 heures.

4. Méthode selon la revendication 2, dans laquelle la poudre de mélange est préparée par mélange des poudres des matériaux de départ à un rapport de mélange prédéterminé, dissolution du mélange dans une solution acide, séchage de la solution pour obtenir une poudre de sels d'acide, chauffage rapidement de la poudre de sels d'acide dans l'air jusqu'à 800°C ou plus, maintien de la poudre à cette température, et refroidissement de la poudre.

# FIG.1

# FIG .2

EP 0 588 240 B1

# FIG . 3

# FIG .4

EP 0 588 240 B1

# FIG. 5

# F I G . 6

# FIG.7A

# FIG.7B